# EUROPÄISCHE PATENTSCHRIFT

(11) **EP 2 797 776 B1**
(45) Veröffentlichungstag und Bekanntmachung des Hinweises auf die Patenterteilung: **25.09.2019**
(21) Anmeldenummer: 12812659.6
(22) Anmeldetag: 21.12.2012
(51) Int. Cl.: B60R 21/017

(54) **VERFAHREN UND VORRICHTUNG ZUR ÜBERWACHUNG EINER ENERGIERESERVE UND SICHERUNGSVORRICHTUNG FÜR EIN FAHRZEUG**
METHOD AND DEVICE FOR MONITORING AN ENERGY RESERVE, AND SAFETY DEVICE FOR A VEHICLE
PROCÉDÉ ET DISPOSITIF DE SURVEILLANCE D'UNE RÉSERVE D'ÉNERGIE ET DISPOSITIF DE SÉCURITÉ POUR UN VÉHICULE

(30) Priorität: 27.12.2011 DE 102011089976
(43) Veröffentlichungstag der Anmeldung: 05.11.2014
(73) Patentinhaber: Robert Bosch GmbH, 70442 Stuttgart (DE)
(72) Erfinder: SIEVERS, Falko, 72762 Reutlingen (DE); SCHUMACHER, Hartmut, 71691 Freiberg (DE); LIST, Carsten, 74399 Walheim (DE)
(86) Internationale Anmeldenummer: PCT/EP2012/076742
(87) Internationale Veröffentlichungsnummer: WO 2013/098260

(56) Entgegenhaltungen:
- EP-A1- 0 577 988
- DE-A1- 19 614 365
- DE-A1- 19 644 858
- DE-A1- 19 709 234
- JP-A- 6 331 669

## Beschreibung

### Stand der Technik

Die vorliegende Erfindung bezieht sich auf ein Verfahren zur Überwachung einer Energiereserve für eine Sicherungseinrichtung für ein Fahrzeug, auf eine entsprechende Vorrichtung, auf eine Sicherungsvorrichtung für ein Fahrzeug sowie auf ein entsprechendes Computerprogrammprodukt.

Airbag-Steuergeräte verfügen über einen eigenen Energiespeicher in Form eines oder mehrerer Aluminium-Elektrolyt-Kondensatoren. Eine solche Energiereserve-Kapazität stellt die volle Funktion des Airbag-Systems auch ohne externe Spannungsversorgung, z. B. bei Abriss der Fahrzeug-Batterie im Crash-Fall, für eine vorgegebene Zeit sicher.

Aus der DE 196 44 858 A1, ist eine Energiespeicherschutzvorrichtung für ein Fahrzeuginsassenschutzsystem bekannt, wobei ein Elektrolytkondensator als Energiespeicher zur Notstromversorgung vorgesehen ist und wobei die Vorrichtung eine Kapazitätsdiagnoseschaltung zur Bestimmung der Kapazität des Elektrolytkondensators durch Entladen desselben umfasst.

Aus der DE 196 14 365 A1 ist eine Diagnoseschaltung zur Prüfung der Kapazität des Stützkondensators bekannt, die eine Prüfschaltung umfasst, in der eine Klemmeinrichtung mit einer Zenerdiode und einem Transistor vorgesehen ist, die parallel zu dem Stützkondensator geschaltet sind.

### Offenbarung der Erfindung

Vor diesem Hintergrund wird mit der vorliegenden Erfindung ein Verfahren zur Überwachung einer Energiereserve für eine Sicherungseinrichtung für ein Fahrzeug, weiterhin eine Vorrichtung, die dieses Verfahren verwendet sowie eine Sicherungsvorrichtung für ein Fahrzeug und schließlich ein entsprechendes Computerprogrammprodukt gemäß den Hauptansprüchen vorgestellt. Vorteilhafte Ausgestaltungen ergeben sich aus den jeweiligen Unteransprüchen und der nachfolgenden Beschreibung.

Fahrzeuge mit einer Sicherungseinrichtung, insbesondere einer Insassenschutzvorrichtung, können über eine eigene Energiereserve für die Sicherungseinrichtung verfügen. Durch die eigene Energiereserve kann ein einwandfreier Betrieb der Sicherungseinrichtung auch bei einem Ausfall einer Hauptspannungsversorgung der Sicherungseinrichtung sichergestellt werden.

Ein Test der Energiereserve kann initial während eines System-Hochlaufs bzw. während des Abschaltens erfolgen. Vorteilhaft ist es jedoch, wenn die Verfügbarkeit der Energiereserve zusätzlich oder alternativ während eines Betriebs des Fahrzeugs, beispielsweise während eines aktuellen Fahrzyklus des Fahrzeugs getestet wird. Eine solche Überwachung während des Fahrzyklus kann beispielsweise kontinuierlich oder zyklisch durchgeführt werden.

Eine Funktionsfähigkeit der Energiereserve kann basierend auf einer Spannungsänderung an der Energiereserve überprüft werden. Damit eine Betriebsbereitschaft der Sicherungseinrichtung auch während der Überprüfung der Energiereserve gewährleistet ist, kann die Spannungsänderung innerhalb eines Spannungsbereichs durchgeführt werden, der durch zulässige Betriebsspannungswerte für die Sicherungseinrichtung begrenzt wird.

Der Ansatz kann beispielsweise bei einem Airbag-System eingesetzt werden. Dabei lässt sich die Güte der Airbag-Steuergeräte-Diagnose verbessern und die zyklische Fehlererkennungsrate kann erhöht werden. Ein vorhandener Hardware-Defekt an der Energiereserve kann damit auch während des Fahrzyklus festgestellt und der Fahrer über die eingeschränkte System-Funktionalität informiert werden.

Vorteilhafterweise lässt sich die Funktionalität der Energiereserve-Kapazität im zyklischen Betrieb testen. Damit wird gewährleistet, dass der Fahrer jederzeit über mögliche Fehler am Energiespeicher informiert werden kann. Das Risiko einer eingeschränkten Auslösebereitschaft des Airbag-Systems ohne vorherige Fehleranzeige wird somit reduziert und entsprechende Kundenanforderungen zur permanenten Überwachung der Energiereserve können erfüllt werden. Eine solche Vorgehensweise bietet Vorteile gegenüber einer Diagnosefähigkeit, die nur initial beziehungsweise zum Ende des Betriebszyklus gegeben ist. Ein weiterer Vorteil des zyklischen Testablaufs liegt darin, dass es nahezu keine Auswirkungen auf andere Funktionen und die System-Verfügbarkeit gibt.

Beispielsweise kann die an der Energiereserve anliegende Spannung während der Spannungsänderung nur so weit abgesenkt werden, dass eine Funktionsfähigkeit von Schaltungsteilen der Sicherungseinrichtung vollständig gewährleistet ist. Andererseits kann die an der Energiereserve anliegende Spannung während der Spannungsänderung beispielsweise nur so weit erhöht werden, dass ein genügend großer Sicherheitsabstand zur Klemmenspannung eines Überspannungsschutzes, beispielsweise eines Schutzes gegen elektrostatische Entladung, auch als ESD-Schutz bezeichnet, gewahrt wird. Der so definierte Spannungsbereich ist groß genug, um die Kapazität der Energiereserve zu bestimmen, ohne die Einsatzbereitschaft der Sicherungseinrichtung zu gefährden.

Die vorliegende Erfindung schafft ein Verfahren zur Überwachung einer Energiereserve für eine Sicherungseinrichtung für ein Fahrzeug, welches folgende Schritte umfasst:
Ändern der an der Energiereserve anliegenden Spannung zwischen einem zum Betreiben der Sicherungseinrichtung geeigneten Startwert und einem zum Betreiben der Sicherungseinrichtung geeigneten Testspannungswert, wobei zum Ändern der Spannung eine Ladeschaltung der Energiereserve deaktiviert wird und eine Entladeschaltung der Energiereserve aktiviert wird; und
Auswerten der Spannungsänderung der an der Energiereserve anliegenden Spannung zwischen dem Startwert und dem Testspannungswert, um die Energiereserve zu überwachen;
wobei die Schritte des Änderns und des Auswertens mehrmals wiederholt während eines Fahrzyklus des Fahrzeugs ausgeführt werden.

Bei dem Fahrzeug kann es sich um ein Kraftfahrzeug, beispielsweise einen Personenkraftwagen, einen Lastkraftwagen oder ein sonstiges Nutzfahrzeug handeln. Unter einer Sicherungseinrichtung kann ein Insassenschutzsystem wie z. B. ein Airbag-System oder Gurtstraffer verstanden werden. Unter einer Energiereserve kann eine Energiereserve-Kapazität wie z. B. ein Aluminium-ElektrolytKondensator, verstanden werden. Im Normalbetrieb kann die Sicherungseinrichtung von einer Energieversorgung mit einer zum Betrieb der Sicherungseinrichtung erforderlichen Betriebsspannung versorgt werden. Die Energiereserve kann im Normalbetrieb von der Energieversorgung aufgeladen werden. Bei einem Ausfall der Energieversorgung, beispielsweise aufgrund eines Unfalls, kann die Energiereserve ausgebildet sein, um die zum Betrieb der Sicherungseinrichtung erforderlichen Betriebsspannung an die Sicherungseinrichtung bereitzustellen. Beispielsweise kann die Energiereserve ausgebildet sein, um eine zur Aktivierung der Sicherungseinrichtung erforderliche Energie bereitzustellen. Durch das Überwachen der Energiereserve kann eine Funktionsfähigkeit der Energiereserve überprüft werden. Insbesondere kann überprüft werden, ob die Energiereserve bei einem Ausfall der Energieversorgung ausreichend Energie zum Betrieb der Sicherungseinrichtung zur Verfügung stellen kann. Das Überwachen der Energiereserve kann während eines Fahrzyklus des Fahrzeugs durchgeführt werden. Der Fahrzyklus kann einem Betriebszyklus des Fahrzeugs entsprechen, der neben einer Fahrt des Fahrzeugs auch betriebsbedingte Halte, wie vor einer Ampel oder im Stopp-and-Go-Verkehr, umfassen kann. Somit kann die Energiereserve während des Betriebs des Fahrzeugs und insbesondere während einer Fahrt des Fahrzeugs überwacht werden. Der Startwert und der Testspannungswert können sich voneinander unterscheiden. Beispielsweise kann es sich bei dem Startwert um einen maximal zum Betreiben der Sicherungseinrichtung geeigneten Betriebsspannungswert und bei dem Testspannungswert um einen minimal zum Betreiben der Sicherungseinrichtung geeigneten Betriebsspannungswert handeln, oder umgekehrt. Auch können der Startwert und der Testspannungswert in einem Spannungsbereich zwischen dem maximal und dem minimal zum Betreiben der Sicherungseinrichtung geeigneten Betriebsspannungswerten angeordnet sein. Auch kann es sich bei dem ersten oder dem Testspannungswert um einen Wert einer normalen Betriebsspannung handeln, die auch dann an der Energiereserve anliegt, wenn gerade keine Überwachung der Energiereserve durchgeführt wird. Zum Betreiben der Sicherungseinrichtung geeignet kann bedeuten, dass die Funktionalität der Sicherungseinrichtung bei dem jeweiligen Betriebsspannungswert gewährleistet ist. Abhängig von dem Auswerten der Spannungsänderung kann ein Überwachungssignal erzeugt werden, das einen Funktionszustand der Energiereserve anzeigen kann.

Der Schritt des Auswertens wird mehrmals wiederholt während eines Fahrzyklus des Fahrzeugs ausgeführt. Das Verfahren wird zyklisch wiederholt ausgeführt. Dadurch kann eine Überwachung der Energiereserve nach vorbestimmten Zeitabständen jeweils erneut durchgeführt werden. Auch kann das Verfahren ansprechend auf ein Auftreten eines oder mehrerer vorgegebenen Ereignisse ausgeführt werden, die während des Fahrzyklus auftreten können. Somit kann die Energiereserve je nach Anforderungsprofil einmal, mehrmals, zu festgelegten Zeitpunkten oder zu sich aus dem Fahrzyklus ergebenen Ereignissen überprüft werden. Eine solche frei definierbare Überwachungsmöglichkeit während des Normalbetriebs des Fahrzeugs stellt eine Verbesserung dar, gegenüber einem initial ausgeführten reinem Ausmessen eines Spannungs-Deltas an der Energiereserve.

In dem Schritt des Änderns wird die an der Energiereserve anliegende Spannung zwischen dem Startwert und dem Testspannungswert geändert, um die Spannungsänderung zu bewirken. Somit kann die Spannungsänderung gezielt herbeigeführt werden, um die Energiereserve überwachen zu können. Die Spannung wird zur Herbeiführung der Spannungsänderung erhöht und erniedrigt. Indem die Spannungsänderung innerhalb des durch den Startwert und den Testspannungswert begrenzten Spannungsbereich erfolgt, kann die Funktionalität der Energiereserve bzw. der Sicherungseinrichtung auch während der Überwachung sichergestellt werden.

Im Schritt des Änderns kann die an der Energiereserve anliegende Spannung zwischen dem Testspannungswert und dem Startwert verändert werden. Diese Veränderung kann entgegengesetzt zu der zur Überwachung der Energiereserve bewirkten Spannungsänderung durchgeführt werden. Durch diese Veränderung kann somit die zur Überwachung der Energiereserve bewirkte Spannungsänderung wieder rückgängig gemacht werden. In diesem Fall kann die Veränderung der Spannung zeitlich nach der zur Überwachung der Energiereserve bewirkten Spannungsänderung erfolgen.

Gemäß einer Ausführungsform kann im Schritt des Auswertens ausgewertet werden, ob die an der Energiereserve anliegende Spannung innerhalb einer vorbestimmten Zeitdauer den Testspannungswert aufgrund der Spannungsänderung erreicht. Die vorbestimmte Zeitdauer kann mit einem Beginn der Spannungsänderung beginnen. In diesem Fall kann die Spannungsänderung ausgehend von dem Startwert solange durchgeführt werden, bis entweder der Testspannungswert innerhalb der vorbestimmten Zeitdauer erreicht wird oder aber die vorbestimmte Zeitdauer abgelaufen ist. Dabei kann der Startwert einem Wert einer normalen Betriebsspannung entsprechen, der auch dann an der Energiereserve anliegt, wenn gerade keine Überwachung der Energiereserve durchgeführt wird. Wird der Testspannungswert innerhalb der vorbestimmten Zeit erreicht, so kann auf einen Ausfall oder eine Fehlfunktion der Energiereserve geschlossen werden. Andernfalls kann die Energiereserve als funktionsfähig angesehen werden.

Dabei kann die an der Energiereserve anliegende Spannung auf den Startwert geändert werden, sobald die an der Energiereserve anliegende Spannung innerhalb der vorbestimmten Zeitdauer den Testspannungswert aufgrund der Spannungsänderung erreicht. Auf diese Weise kann verhindert werden, dass die Spannung zu weit absinkt, wodurch die Einsatzbereitschaft der Sicherungseinrichtung gefährdet werden könnte. Fällt die an der Energiereserve anliegende Spannung innerhalb der vorbestimmten Zeitdauer nicht bis auf den Testspannungswert ab, so kann die an der Energiereserve anliegende Spannung bei Ablauf der vorbestimmten Zeitdauer wieder auf den Startwert geändert werden.

Gemäß einer weiteren Ausführungsform kann im Schritt des Auswertens eine Zeitdauer der Spannungsänderung zwischen dem Startwert und dem Testspannungswert ausgewertet werden. In diesem Fall kann die Spannungsänderung ausgehend von dem Startwert solange durchgeführt werden, bis der Testspannungswert erreicht wird. Eine Kapazität der Energiereserve kann bei Kenntnis des während der Spannungsänderung fließenden Stroms, der Spannungsdifferenz der Spannungsänderung und der Zeitdauer, mit einer hohen Genauigkeit bestimmt werden.

Bei den unterschiedlichen Ausführungsformen kann der Startwert kleiner als der Testspannungswert sein.

Die vorliegende Erfindung schafft ferner eine Vorrichtung zur Überwachung einer Energiereserve für eine Sicherungseinrichtung für ein Fahrzeug mit den Merkmalen des Anspruchs 7.

Die vorliegende Erfindung schafft ferner eine Sicherungsvorrichtung für ein Fahrzeug mit folgenden Merkmalen:
einer Sicherungseinrichtung;
einer Energiereserve für die Sicherungseinrichtung;
einer Ladeschaltung zum Laden der Energiereserve;
einer Entladeschaltung zum Entladen der Energiereserve; und
einer Vorrichtung zur Überwachung der Energiereserve.

Von Vorteil ist auch ein Computerprogrammprodukt mit Programmcode, der auf einem maschinenlesbaren Träger wie einem Halbleiterspeicher, einem Festplattenspeicher oder einem optischen Speicher gespeichert sein kann und zur Durchführung des Verfahrens nach einer der vorstehend beschriebenen Ausführungsformen verwendet wird, wenn das Programm auf einem Computer ausgeführt wird.

Die Erfindung wird nachstehend anhand der beigefügten Zeichnungen beispielhaft näher erläutert. Es zeigen:
- Fig. 1a: eine schematische Darstellung eines Fahrzeugs mit einer Vorrichtung zur Überwachung der Energiereserve, gemäß einem Ausführungsbeispiel der vorliegenden Erfindung;
- Fig. 1b: ein Blockschaltbild eines Ausführungsbeispiels der vorliegenden Erfindung;
- Fig. 1c: eine Vorrichtung zur Überwachung einer Energiereserve für eine Sicherungseinrichtung für ein Fahrzeug gemäß einem Ausführungsbeispiel der vorliegenden Erfindung;
- Fig. 2: eine grafische Darstellung einer an einer Energiereserve für eine Sicherungseinrichtung anstehenden Spannung während eines Überwachungsvorgangs gemäß einem Ausführungsbeispiel der vorliegenden Erfindung;
- Fig. 3: eine grafische Darstellung der an einer Energiereserve für eine Sicherungseinrichtung anstehenden Spannung gemäß einem Ausführungsbeispiel der vorliegenden Erfindung;
- Fig. 4: eine grafische Darstellung der an einer Energiereserve für eine Sicherungseinrichtung anstehenden Spannung gemäß einem weiteren Ausführungsbeispiel der vorliegenden Erfindung; und
- Fig. 5: ein Ablaufdiagramm eines Verfahrens zur Überwachung einer Energiereserve für eine Sicherungseinrichtung für ein Fahrzeug gemäß einem Ausführungsbeispiel der vorliegenden Erfindung.

In der nachfolgenden Beschreibung bevorzugter Ausführungsbeispiele der vorliegenden Erfindung werden für die in den verschiedenen Figuren dargestellten und ähnlich wirkenden Elemente gleiche oder ähnliche Bezugszeichen verwendet, wobei auf eine wiederholte Beschreibung dieser Elemente verzichtet wird.

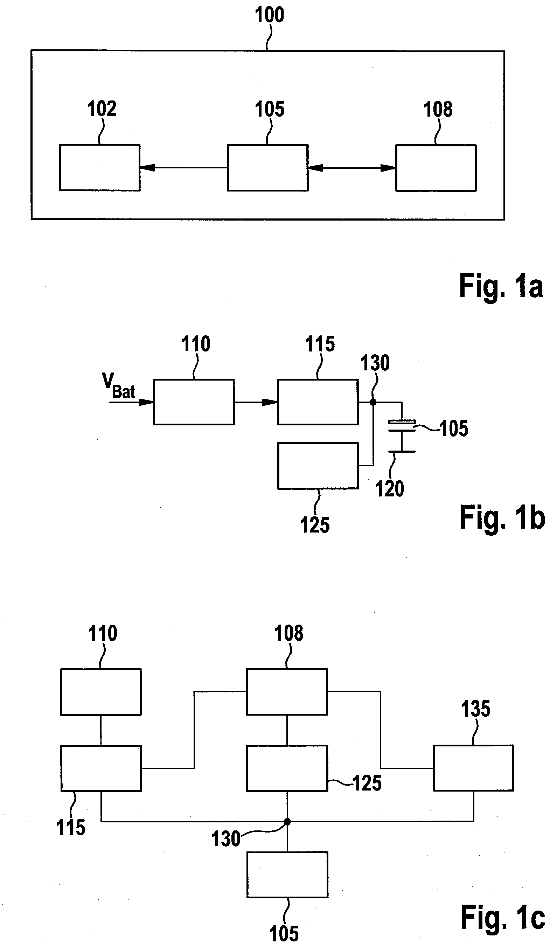

Fig. 1a zeigt eine schematische Darstellung eines Fahrzeugs 100 mit einer Sicherungseinrichtung 102, einer Energiereserve 105 für die Sicherungseinrichtung 102 und einer Vorrichtung 108 zur Überwachung der Energiereserve 105 gemäß einem Ausführungsbeispiel der vorliegenden Erfindung.

Bei der Sicherungseinrichtung 102 kann es sich um ein Airbag-System handeln, das beispielsweise zumindest einen Airbag und ein Steuergerät zur Steuerung des zumindest einen Airbags aufweist. Die Sicherungseinrichtung 102 kann aber auch ein anderes Insassenschutzsystem darstellen. Beispielsweise kann die Sicherungseinrichtung 102 zusätzlich oder alternativ zu einem Airbag andere Rückhaltemittel, Gurtstraffer, Überrollbügel oder ähnliches, und entsprechende Ansteuerungen umfassen. Die Energiereserve 105 ist mit der Sicherungseinrichtung 102 verbunden und ausgebildet, um zumindest beim Ausfall einer Hauptenergieversorgung der Sicherungseinrichtung 102 Energie zum Betrieb der Sicherungseinrichtung 102 bereitzustellen. Die Vorrichtung 108 zur Überwachung ist mit der Energiereserve 105 gekoppelt, um eine Funktionsfähigkeit der Energiereserve 105 zu überwachen. Dazu ist die Vorrichtung 108 zur Überwachung ausgebildet, um eine Spannungsänderung an der Energiereserve 105 auszuwerten. Ferner kann die Vorrichtung 108 zur Überwachung ausgebildet sein, um die Spannungsänderung an der Energiereserve 105 durchzuführen.

Fig. 1b zeigt ein Blockschaltbild einer Lade- und Entladeschaltung einer Energiereserve 105 gemäß einem Ausführungsbeispiel der vorliegenden Erfindung. Bei der Energiereserve 105 kann es sich um die in Fig. 1a gezeigte Energiereserve für eine Sicherungseinrichtung eines Fahrzeugs handeln. Die Schaltung umfasst einen Wandler 110, der als DC/DC-Aufwärtswandler ausgeführt ist, eine Ladeschaltung 115 für die gegen Masse 120 geschaltete Energiereserve 105 und eine Entladeschaltung 125 für die Energiereserve 105.

Der Aufwärtswandler 110 wird an einem Eingang von einer Bordbatterie des Fahrzeugs mit der Spannung V_{Bat} gespeist. Ein Ausgang des Aufwärtswandlers 110 ist mit der integrierten Ladeschaltung 115 für die Energiereserve 105 verbunden und stellt eine aus der Spannung V_{Bat} gewandelte Spannung an einen Eingang der Ladeschaltung 115 bereit. Ein Ausgang der Ladeschaltung 115 ist verbunden mit einem Anschluss der Energiereserve 105. Die Ladeschaltung 115 ist ausgebildet, um eine Ladespannung zum Aufladen der Energiereserve 105 an die Energiereserve 105 bereitzustellen. Ein weiterer Anschluss der Energiereserve 105 ist mit der Masse 120 verbunden. Parallel zur Ladeschaltung 115 ist die Entladeschaltung 125 zur Entladung der Energiereserve 105 positioniert. Ein Anschluss der Schaltung 125 zur Entladung der Energiereserve ist verbunden mit einem Knotenpunkt 130. Der Knotenpunkt befindet sich weiterhin zwischen der Schaltung 115 für die Ladung der Energiereserve und einem Anschluss der Energiereserve 105. An dem Knotenpunkt 130 kann eine Spannungsmessung durchgeführt werden, wobei die Messung entweder per Analog/Digital-Wandler oder mittels einer Schaltung mit festen Komparator-Schwellen erfolgen kann. Beispielsweise kann die Messung von der in Fig. 1a gezeigten Vorrichtung zur Überwachung der Energiereserve durchgeführt werden. Die Ladeschaltung 115 und die Entladeschaltung 125 können jeweils Steuereingänge aufweisen, über die eine Ladefunkion der Ladeschaltung 115 sowie eine Entladefunktion der Entladeschaltung 125 gesteuert werden können. Eine entsprechende Steuerung kann beispielsweise von der Vorrichtung zur Überwachung der Energiereserve durchgeführt werden.

Bei einem Ausfall der Batteriespannung V_{Bat} kann die Sicherungseinrichtung über die Energiereserve 105 betrieben werden.

Im Folgenden wird anhand von Fig. 1b ein Ausführungsbeispiel der vorliegenden Erfindung in Bezug zu einem Airbag-System eines Fahrzeugs beschrieben. Das Airbag-System weist die Energiereserve 105 auf. Gezeigt ist in Fig. 1b ein Blockschaltbild der Energiereserve-Lade-/Entladeschaltung des Airbag-Systems.

Die Spannungsversorgungskonzepte von Airbag-Systemen sehen vor, dass alle Systemkomponenten für den Fall einer Batterieabtrennung, d. h. beispielsweise ein Abriss im Crash-Fall, auch autark aus dem separaten Energiespeicher 105, hier einer Energiereserve-Kapazität, zumindest zeitweise versorgt werden können. Dieser Systemzustand wird Autarkie genannt.

Mithilfe der integrierten Ladeschaltung in Form des DC/DC-Schaltwandlers 110 inklusive Strombegrenzung 115 wird die Energiereserve 105 zunächst auf ein hohes Spannungsniveau (z. B. 33V) aufgeladen und dient dann als zentrale Versorgungsquelle des gesamten Airbag-Systems in Autarkie. Der Kapazitätswert der Energiereserve 105 wird initial, während des System-Hochlaufs, vermessen und mittels Software-Diagnose im Airbag-System bewertet. Im Falle einer defekten, d. h. zu kleinen, Energiereserve-Kapazität wird ein System-Fehler gespeichert und der Fahrer durch die aktivierte Airbag-Warnlampe informiert. Tritt der Defekt an der Energiereserve-Kapazität erst im Lauf des Betriebszyklus auf, kann dieser mittels einer Diagnose und Fehleranzeige im aktuellen Zyklus behandelt werden. Es ist also möglich, vorhandene Fehler an der Energiereserve-Kapazität 105 auch zyklisch zu detektieren und den Fahrer bei Einfluss auf die Systemverfügbarkeit zu informieren. Zentraler Mechanismus des Tests ist es, die anliegende Spannung an der Energiereserve 105 vom Nominalwert 33V kurzzeitig auf ein abweichendes Niveau zu erhöhen bzw. zu reduzieren und diesen Vorgang zu überwachen. Die Spannungsänderung wird dabei so gering gehalten, dass keine anderen Schaltungsteile gestört werden oder die Autarkiezeit beeinflusst wird. Beispielsweise würde ein zu starkes Absenken der Spannung am Energiereserve-Elko die Autarkiezeit verkürzen, wenn der Batterieabriss unmittelbar nach Teststart eintritt.

Fig. 1c zeigt eine Schaltung mit einer Vorrichtung 108 zur Überwachung einer Energiereserve 105 für eine Sicherungseinrichtung für ein Fahrzeug gemäß einem Ausführungsbeispiel der vorliegenden Erfindung. Gezeigt ist die bereits anhand von Fig. 1b beschriebene Anordnung aus einem Wandler 110, einer Ladeschaltung 115 und einer Entladeschaltung 125. Anschlüsse der Ladeschaltung 115, der Entladeschaltung 125 und der Energiereserve 105 sind über einen gemeinsamen Knotenpunkt 130 miteinander verbunden.

Eine Erfassungseinrichtung 135 ist mit dem Knotenpunkt 130 verbunden. Die Erfassungseinrichtung 135 ist ausgebildet, um eine Spannungsmessung an dem Knotenpunkt 130 durchzuführen. Somit ist die Erfassungseinrichtung 135 ausgebildet, um eine an der Energiereserve 105 anliegende Spannung zu erfassen. Die Erfassungseinrichtung 135 ist ausgebildet, um Werte der erfassten Spannung an die Vorrichtung 108 bereitzustellen.

Im Normalbetrieb wird die Sicherungseinrichtung von einer Energieversorgung mit einer zum Betrieb der Sicherungseinrichtung erforderlichen Betriebsspannung versorgt. Die Energiereserve 105 wird im Normalbetrieb von der Energieversorgung aufgeladen. Bei einem Ausfall der Energieversorgung, beispielsweise aufgrund eines Unfalls, ist die Energiereserve 105 ausgebildet, um die zum Betrieb der Sicherungseinrichtung erforderliche Betriebsspannung an die Sicherungseinrichtung bereitzustellen. Die Energiereserve 105 ist dimensioniert, um eine zur Aktivierung der Sicherungseinrichtung erforderliche Energie bereitzustellen. Die Vorrichtung 108 ist ausgebildet, um zu überwachen, ob die Energiereserve 105 im Falle eines Ausfalls der Energieversorgung ausreichend Energie zum Betrieb der Sicherungseinrichtung zur Verfügung stellen kann.

Hierzu ist die Vorrichtung 108 ausgebildet, um die Ladeschaltung 115 und die Entladeschaltung 125 anzusteuern, um eine Spannungsänderung an der Energiereserve 105 zu bewirken. Die Vorrichtung 108 ist ausgebildet, um die von der Erfassungseinrichtung 135 erfasste Spannungsänderung auszuwerten und abhängig von der Auswertung der Spannungsänderung eine Entscheidung darüber zu treffen, ob die Energiereserve 105 fehlerfrei funktioniert oder aber defekt ist. Wird die Energiereserve 105 als defekt eingestuft, so kann die Vorrichtung 108 ein Warnsignal ausgeben, das auf den Defekt der Energiereserve 105 hinweist.

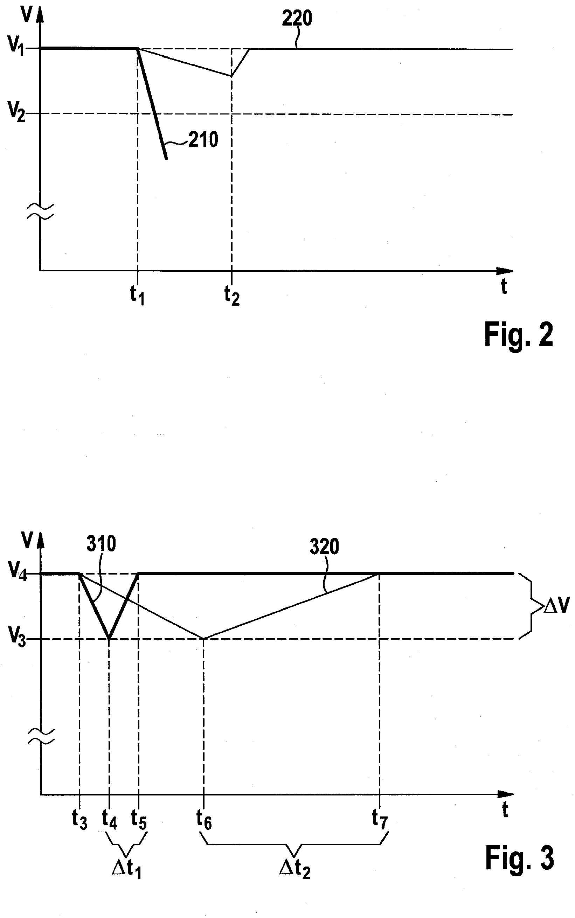

Je nach Ausführungsbeispiel ist die Vorrichtung 108 ausgebildet, um durch Steuerung der Ladeschaltung 115 und der Entladeschaltung 125 die Zeit oder die Spannung während eines Ladevorgangs oder alternativ eines Entladevorgangs der Energiereserve 105 zu überwachen. Die Figuren 2 bis 4 zeigen Spannungskurven für entsprechende Ausführungsbeispiele der vorliegenden Erfindung.

Gemäß einem Ausführungsbeispiel der vorliegenden Erfindung, das nachfolgend anhand von Fig. 2 näher beschrieben wird, wird für einen Überwachungsvorgang der Energiereserve 105 die Ladeschaltung 115 deaktiviert und die Entladeschaltung 125 aktiviert. Die Vorrichtung 108 ist ausgebildet, um den ab dem Zeitpunkt der Entladung von der Erfassungseinrichtung 135 erfassten Spannungsabfall an der Energiereserve 105 auszuwerten. Wenn die an der Energiereserve 105 anliegende Spannung in einer vordefinierten Zeit ab dem Zeitpunkt der Entladung einen vordefinierten Schwellwert nicht unterschreitet, wird die Energiereserve 105 als ausreichend erkannt. Wenn in der vordefinierten Zeit ab dem Zeitpunkt der Entladung die an der Energiereserve 105 anliegende Spannung unter den vordefinierten Wert sinkt, ist die Vorrichtung 108 ausgebildet, um die Entladeschaltung 125 von der Energiereserve 105 zu trennen und die Ladeschaltung 115 zu aktivieren. Auf diese Weise kann verhindert werden, dass die Spannung an der Energiereserve 105 aufgrund der Überwachung zu weit absinkt und somit die Einsatzbereitschaft der Sicherungseinrichtung gefährdet wird. In diesem Fall wird die Energiereserve 105 als defekt betrachtet. Die Vorrichtung 108 ist ausgebildet, um ein Signal zur Anzeige der defekten Energiereserve 105 ausgegeben.

Ferner können weitere Maßnahmen durchgeführt werden, die dafür sorgen sollen, die Entladung der Energiereserve 105 bei einer bevorstehenden Airbag-Auslösung zu unterdrücken bzw. schnellstmöglich abzubrechen. Dadurch kann verhindert werden, dass bei einem bevorstehenden Einsatzfall der Energiereserve 105 eine Überwachung der Energiereserve 105 durchgeführt wird. So kann eine zusätzliche Testverriegelung bzw. ein Abbruch der Überwachung bei Erkennung eines Batterie-Abriss durchgeführt werden. Der Batterie-Abriss kann anhand einer V_{Bat}-Unterspannungschwelle erkannt werden, d. h., daran, dass ein Spannungsabfall bis zur V_{Bat}-Unterspannungschwelle erfolgt. Ferner kann eine Verriegelung des Tests der Energiereserve 105 durchgeführt werden, sobald im System-ASIC Auslöse-relevante Signale anliegen, wie z. B. die Freigabe der Zündkreise. Auch kann der Test der Energiereserve 105 durch Software nicht gestartet werden, wenn im System erste Crash-informationen erkannt wurden. D.h. sobald der Pre-Fire oder Crash-Algorithmus aktiv wird.

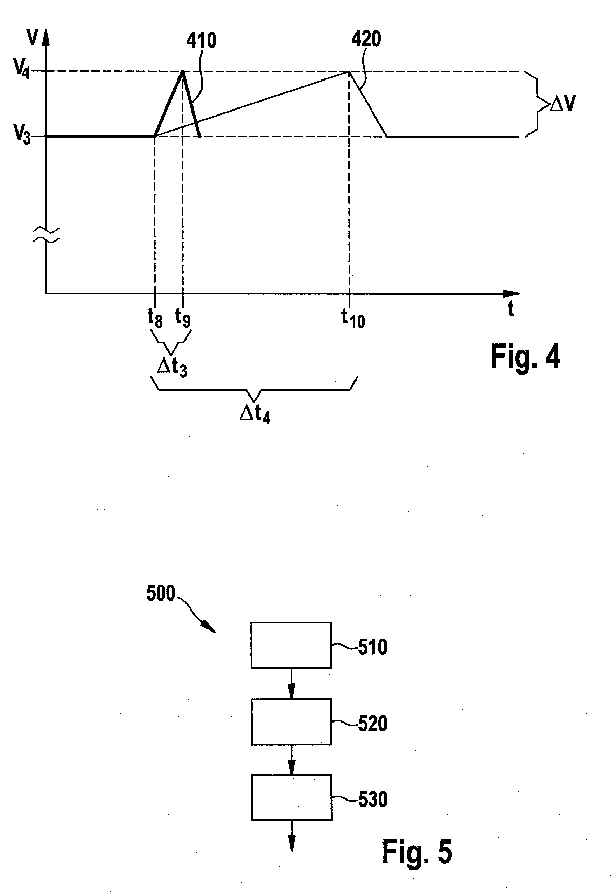

In weiteren Ausführungsbeispielen, die nachfolgend anhand der Figuren 3 und 4 näher beschrieben sind, wird anstelle des Entladevorgangs der Ladevorgang überwacht. Gemäß dem nachfolgend anhand von Fig. 3 näher beschriebenen Verfahren findet dabei zuerst eine teilweise Entladung der Energiereserve 105 statt. Anschließend wird die Energiereserve wieder aufgeladen und eine Zeitdauer des Wiederaufladens wird von der Vorrichtung 108 ausgewertet. Dazu ist die Vorrichtung ausgebildet, um die Ladeschaltung 115 von der Energiereserve 105 zu trennt und die Entladeschaltung 125 zuzuschalten, bis die Betriebsspannung an der Energiereserve 105 ausgehend von einem normalen Betriebsspannungswert einen unteren Schwellwert erreicht. Die Einhaltung des Schwellwerts wird an dem Knoten 130 mittels der Erfassungseinrichtung 135 von der Vorrichtung 108 überwacht. Sobald der untere Schwellwert erreicht ist, ist die Vorrichtung 108 ausgebildet, um die Entladeschaltung 125 von der Energiereserve 105 zu trennen und die Ladeschaltung 115 wieder zu aktivieren. Der nachfolgende Ladevorgang der Energiereserve 105 wird bis zum normalen Betriebsspannungswert durchgeführt. Die Vorrichtung 108 ist ausgebildet, um eine Zeitdauer des Ladevorgangs zu ermitteln und auszuwerten. Abhängig von der Zeitdauer ist die Vorrichtung 108 ausgebildet, um zu entscheiden, ob die Energiereserve funktionsfähig oder defekt ist.

Gemäß einem nachfolgend anhand von Fig. 4 näher beschriebenen Verfahren wird die Energiereserve 105 ausgehend von der normalen Betriebsspannung zunächst weiter aufgeladen und anschließend wieder entladen. Dabei wird die Zeitdauer des Aufladens von der Vorrichtung 108 ausgewertet. Anstelle die Betriebsspannung ausgehend vom normalen Betriebsspannungswert mittels der Entladeschaltung 125 zuerst zu senken, ist es somit auch möglich, die Betriebsspannung vom Normalbetrieb aus bis zu einem oberen Schwellwert der Betriebsspannung zu erhöhen. Für diesen Ladevorgang wird von der Vorrichtung 108 ein neuer Sollwert für die Betriebsspannung oder Ladespannung an die Ladeschaltung 115 vorgegeben. Eine durch den Ladevorgang hervorgerufene Spannungsänderung an dem Knotenpunkt 130 wird von der Erfassungseinrichtung 135 erfasst und von der Vorrichtung 108 ausgewertet. Eine aufgrund des Ladevorgangs bewirkte Spannungsänderung sowie die Zeitdauer des Ladevorgangs bilden die Basis zur Berechnung der in der Energiereserve 105 vorhandenen Kapazität, welche mit einem Sollwert in der Vorrichtung 108 verglichen wird. Liegt die Kapazität der Energiereserve 105 unter dem vorgegebenen Sollwert für die Kapazität der Energiereserve 105, wird ein Überwachungssignal für eine defekte Energiereserve 105 ausgegeben. Nach dem Erreichen des oberen Schwellwerts für die Betriebsspannung, wodurch ein Ende des Ladevorgangs markiert wird, ist die Vorrichtung 108 ausgebildet, um entsprechende Steuersignale auszugeben, sodass die Ladeschaltung 115 von der Energiereserve 105 getrennt wird, die Entladeschaltung 125 mit der Energiereserve 105 verbunden wird und die an der Energiereserve 105 anliegende Spannung wieder auf den für den Normalbetrieb bestimmten Wert gesenkt. Sobald der Wert der Betriebsspannung für den Normalbetrieb erreicht wird, ist die Vorrichtung 108 ausgebildet, um entsprechende Steuersignale auszugeben, damit die Ladeschaltung 115 wieder mit der Energiereserve 105 verbunden wird und die Entladeschaltung 125 von der Energiereserve getrennt wird. Damit ist der zu Beginn herrschende Zustand wieder erreicht und die Überwachung kann zyklisch wiederholt werden.

Durch das Überwachen der Energiereserve kann eine Funktionsfähigkeit der Energiereserve überprüft werden. Insbesondere kann überprüft werden, ob die Energiereserve bei einem Ausfall der Energieversorgung ausreichend Energie zum Betrieb der Sicherungseinrichtung zur Verfügung stellen kann. Das Überwachen der Energiereserve kann während eines Fahrzyklus des Fahrzeugs mehrmalig, beispielsweise in vorbestimmten zeitlichen Abständen, wiederholt werden. Der Fahrzyklus kann einem Betriebszyklus des Fahrzeugs entsprechen, der neben einer Fahrt des Fahrzeugs auch betriebsbedingte Halte, wie vor einer Ampel oder im Stopp-and-Go-Verkehr, umfassen kann. Somit kann die Energiereserve während des Betriebs des Fahrzeugs und insbesondere während einer Fahrt des Fahrzeugs überwacht werden.

Die Figuren 2 bis 4 zeigen Spannungsverläufe der Betriebsspannung während eines Überwachungszyklus der Energiereserve für eine Sicherungseinrichtung in einem Fahrzeug gemäß verschiedener Ausführungsbeispiele der vorliegenden Erfindung.

Fig. 2 zeigt eine grafische Darstellung der an einer Energiereserve für eine Sicherungseinrichtung anstehenden Spannung gemäß einem Ausführungsbeispiel der vorliegenden Erfindung. Bei der Energiereserve kann es sich um die in den Figuren 1a, 1b und 1c gezeigte Energiereserve für eine Sicherungseinrichtung handeln. Gezeigt ist ein Verlauf der Spannung in einem kartesischen Koordinatensystem während eines Überwachungsvorgangs der Energiereserve. Auf der Abszisse ist die Zeit t und auf der Ordinate die an der Energiereserve anstehende Spannung V dargestellt.

Auf der Ordinate sind ein Startwert V₁ und ein Testspannungswert V₂ markiert. Die Werte für V₁ und V₂ sind als gestrichelte Grenzlinien im Koordinatensystem eingezeichnet. Zwei Kurvenverläufe 210, 220 zeigen zwei verschiedene Spannungskurven während eines Überwachungsvorgangs eines Ausführungsbeispiels des erfindungsgemäßen Verfahrens. Bis zu einem Zeitpunkt t₁ weist die Spannung den Wert V₁ auf. Der Wert V₁ entspricht somit einer normalen Betriebsspannung der Energiereserve. Der Überwachungsvorgang beginnt zum Zeitpunkt t₁. Ab dem Zeitpunkt t₁ wird mit einer Entladung de Energiereserve begonnen. Die Entladung wird spätestens zu einem nachfolgenden Zeitpunkt t₂ beendet.

Die Spannungskurve 210 zeigt einen Spannungsverlauf, der auf einen Defekt der Energiereserve hindeutet. Dagegen zeigt die Spannungskurve 220 einen Spannungsverlauf, der auf eine korrekte Funktion der Energiereserve hindeutet.

Die Spannungskurve 210 verläuft bis zum Zeitpunkt t₁ auf dem Niveau des Startwerts V₁. Zum Zeitpunkt t₁ fällt die Spannungskurve 210 steil ab und schneidet bereits vor dem Zeitpunkt t₂ den durch den Testspannungswert V₂ definierten unteren Grenzwert für die an der Energiereserve anliegende Spannung.

Die Spannungskurve 220 verläuft bis zum Zeitpunkt t₁ auf dem Niveau des Startwerts V₁. Zum Zeitpunkt t₁ fällt die Spannungskurve 220 langsam ab und erreicht bis zum Zeitpunkt t₂ nicht den durch den Testspannungswert V₂ definierten unteren Grenzwert für die an der Energiereserve anliegende Spannung.

Die in Fig. 2 dargestellte Darstellung eines Ausführungsbeispiels einer erfindungsgemäßen Überwachung der an der Energiereserve für eine Sicherungseinrichtung anstehenden Spannung zeigt bei dem Spannungsverlauf 210 einen Test einer defekten Energiereserve, wohingegen der Spannungsverlauf 220 einen Test einer korrekt funktionierenden Energiereserve repräsentiert. In dem in Fig. 2 gezeigten Ausführungsbeispiel eines erfindungsgemäßen Verfahrens ist das Zeitintervall zwischen dem Zeitpunkt t₁ und dem Zeitpunkt t₂ vorab definiert.

Das in Fig. 2 dargestellte Verfahren kann beschrieben werden als Verfahren, bei dem der Startwert V₁ größer ist als der Testspannungswert V₂ ist. Es wird der Spannungsabfall während der zwischen den Zeitpunkten t₁ und t₂ liegenden Zeitdauer erfasst und ausgewertet. Um den Spannungsabfall zu bewirken, wird eine Ladeschaltung der Energiereserve deaktiviert und eine Entladestromquelle der Energiereserve aktiviert werden. Das in Fig. 2 dargestellte Verfahren kann somit beschrieben werden als Verfahren, bei dem im Schritt des Auswertens ein Betrag der Spannungsänderung innerhalb einer vorbestimmten Zeitdauer ausgewertet wird.

Gemäß einem Ausführungsbeispiel wird durch kurzzeitiges Deaktivieren (z. B. 10ms) der Energiereserve-Ladeschaltung und zusätzlichem Einschalten einer strombegrenzten Entladestromquelle (z. B. 5mA) die Spannung an der Energiereserve aktiv abgesenkt. Wird dabei eine festgelegte Spannungsschwelle V₂ (z. B. 31V, also 2V unterhalb des Nominalwertes V₁ von 33V) innerhalb einer festgelegten Zeit unterschritten, so kann auf einen Komplettausfall der Energiereserve-Kapazität geschlossen werden, z. B. durch den Abriss des Elkos bzw. einer fehlerhaften Lötstelle und/oder Leiterbahn beziehungsweise Kontaktierung. Die Überwachung der festgelegten Schwellen V₁, V₂ kann dabei direkt in der Hardware, z. B. durch Komparatoren, oder mittels Messungen über einen ADC erfolgen.

Fig. 3 zeigt eine grafische Darstellung der an einer Energiereserve für eine Sicherungseinrichtung anstehenden Spannung gemäß einem Ausführungsbeispiel der vorliegenden Erfindung. Bei der Energiereserve kann es sich um die in den Figuren 1a, 1b und 1c gezeigte Energiereserve für eine Sicherungseinrichtung handeln. Gezeigt ist ein Verlauf der Spannung in einem kartesischen Koordinatensystem während eines Überwachungsvorgangs der Energiereserve. Auf der Abszisse ist die Zeit t und auf der Ordinate die an der Energiereserve für eine Sicherungseinrichtung anstehende Spannung V dargestellt.

Auf der Ordinate sind ein Startwert V₃ und ein Testspannungswert V₄ markiert. Die Werte für V₃ und V₄ sind als gestrichelte Grenzlinien im Koordinatensystem eingezeichnet. Zwei Kurvenverläufe 310, 320 zeigen zwei verschiedene Spannungskurven während eines Überwachungsvorgangs eines Ausführungsbeispiels des erfindungsgemäßen Verfahrens.

Die Spannungskurve 310 zeigt einen Spannungsverlauf, der auf einen Defekt der Energiereserve hindeutet. Dagegen zeigt die Spannungskurve 320 einen Spannungsverlauf, der auf eine korrekte Funktion der Energiereserve hindeutet.

Die Spannungskurve 310 verläuft bis zum Zeitpunkt t₃ auf dem Niveau des Testspannungswerts V₄ und sinkt dann geradlinig bis zum Zeitpunkt t₄ auf das Niveau des Startwerts V₃. Zwischen dem Zeitpunkt t₄ und dem Zeitpunkt t₅ steigt die Spannungskurve 310 auf das Niveau der zweiten Betriebsspannung V₄. Das Zeitintervall Δt₁ ist definiert als die Zeitspanne zwischen dem Zeitpunkt t₄ und dem Zeitpunkt t₅. Die Spannungsdifferenz ΔV ist definiert als der Betrag der Differenz aus dem Startwert V₃ und dem Testspannungswert V₄. Die zweite Spannungskurve 320 verläuft bis zum Zeitpunkt t₃ auf dem Niveau des Testspannungswerts V₄ und sinkt dann geradlinig bis zum Zeitpunkt t₆ auf das Niveau des Startwerts V3. Zwischen dem Zeitpunkt t₆ und dem Zeitpunkt t₇ steigt die Spannungskurve 320 auf das Niveau der zweiten Betriebsspannung V₄. Das Zeitintervall Δt₂ ist definiert als die Zeitspanne zwischen dem Zeitpunkt t₆ und dem Zeitpunkt t₇. Bei dem in Fig. 3 dargestellten Ausführungsbeispiel wird die Zeitdifferenz Δt₁, Δt₂ bewertet, um eine Aussage über die Funktionalität der Energiereserve zu treffen. Im Schritt des Auswertens kann ein Anstieg über eine Zeit während eines Ladevorgangs vom kleineren Betriebsspannungswert V₃ zum im Vergleich dazu größeren Betriebsspannungswert V₄ ausgewertet wird, um die Kapazität der Energiereserve zu berechnen.

Die in Fig. 3 dargestellte Darstellung eines Ausführungsbeispiels einer erfindungsgemäßen Überwachung der an der Energiereserve für eine Sicherungseinrichtung anstehenden Spannung zeigt bei dem Spannungsverlauf 310 einen Test einer defekten Energiereserve, wohingegen der Spannungsverlauf 320 einen Test einer korrekt funktionierenden Energiereserve repräsentiert. In dem in Fig. 3 gezeigten Ausführungsbeispiel eines erfindungsgemäßen Verfahrens ist die Spannungsdifferenz zwischen dem Startwert V₃ und dem Testspannungswert V₄ vorab definiert.

Das in Fig. 3 dargestellte Verfahren kann beschrieben werden als Verfahren, bei dem der Startwert V₃ kleiner ist als der Testspannungswert V₄ ist. Es wird der Spannungsgewinn ΔV und das Zeitintervall zwischen einem ersten Zeitpunkt t₄, t₆ und einem zweiten Zeitpunkt t₅, t₆ erfasst und ausgewertet. Um den Spannungsabfall vor dem Ladevorgang zu bewirken, wird eine Ladeschaltung der Energiereserve deaktiviert und eine Entladestromquelle der Energiereserve aktiviert werden. Wird der untere Betriebsspannungswert V₃ erreicht, so wird es wieder umgekehrt, d. h. die Entladestromquelle deaktiviert und die Ladestromschaltung aktiviert. Das in Fig. 3 dargestellte Verfahren kann somit beschrieben werden als Verfahren, bei dem im Schritt des Auswertens ein Betrag der Zeitspanne innerhalb einer vorbestimmten Spannungsdifferenz ausgewertet wird.

Wie bei dem in Fig. 2 gezeigten Ausführungsbeispiel, wird in dem in Fig. 3 gezeigten Ausführungsbeispiel die Energiereserve während des zyklischen Tests mittels der Entladestromquelle entladen. Die Entladezeit, d. h. die Zeitspanne zwischen t₃ und t₄, und das erlaubte Entlade-Spannungsniveau V₃ können dabei projektspezifisch angepasst werden und sind in der Steuergeräte-Software hinterlegt. Wurde das vorgegebene Entlade-Spannungsniveau V₃ erreicht, wird die Spannung an der Energiereserve wieder auf den Nominalwert V₄ aufgeladen. Der verwendete Ladestrom kann projektspezifisch programmiert werden und ist sehr genau. Der Spannungsanstieg ΔV an der Energiereserve während des Aufladens wird dabei mittels ADC-Messungen überwacht und gegen Vorgabewerte verglichen. Es ist so möglich, die Energiereserve-Kapazität mit einer hohen Genauigkeit zu bestimmen (C=I^{∗}t/U). Erfüllt der ermittelte Kapazitätswert die geforderten Anforderungen nicht, d. h. er, ist zu klein, kann ein entsprechender Fehler gespeichert und der Fahrer informiert werden.

Gemäß einem Ausführungsbeispiel erfolgt die Entladung von dem ursprünglichen Spannungswert V₄ auf den Startwert V₃ allein durch Leckströme an der Energiereserve. Dies dauert im Vergleich zu einer aktiven Entladung deutlich länger, jedoch kann die Entladestromquelle ggf. eingespart werden. Da nur die anschließende Aufladung ausgemessen wird, spielt die Dauer der Entladung keine Rolle und es kann auch ohne festgelegte Zeit bis auf die Schwelle V₃ entladen werden.

Fig. 4 zeigt eine grafische Darstellung der an einer Energiereserve für eine Sicherungseinrichtung anstehenden Spannung gemäß einem Ausführungsbeispiel der vorliegenden Erfindung. Bei der Energiereserve kann es sich um die in den Figuren 1a, 1b und 1c gezeigte Energiereserve für eine Sicherungseinrichtung handeln. Gezeigt ist ein Verlauf der Spannung in einem kartesischen Koordinatensystem während eines Überwachungsvorgangs der Energiereserve. Auf der Abszisse ist die Zeit t und auf der Ordinate die an der Energiereserve für eine Sicherungseinrichtung anstehende Spannung V dargestellt.

Auf der Ordinate sind ein Startwert V₃ und ein Testspannungswert V₄ markiert. Die Werte für V₃ und V₄ sind als gestrichelte Grenzlinien im Koordinatensystem eingezeichnet. Zwei Kurvenverläufe 410, 420 zeigen zwei verschiedene Spannungskurven während eines Überwachungsvorgangs eines Ausführungsbeispiels des erfindungsgemäßen Verfahrens.

Die Spannungskurve 410 zeigt einen Spannungsverlauf, der auf einen Defekt der Energiereserve hindeutet. Dagegen zeigt die Spannungskurve 420 einen Spannungsverlauf, der auf eine korrekte Funktion der Energiereserve hindeutet.

Die Spannungskurve 410 verläuft bis zum Zeitpunkt t8 auf dem Niveau des Startwerts V₃ und steigt dann geradlinig bis zum Zeitpunkt tg auf das Niveau des Testspannungswerts V₄. Nach dem Zeitpunkt tg sinkt die Spannungskurve 410 wieder auf das Niveau der ersten Betriebsspannung V₃. Das Zeitintervall Δt₃ ist definiert als die Zeitspanne zwischen dem Zeitpunkt t₈ und dem Zeitpunkt t₉. Die Spannungsdifferenz ΔV ist definiert als der Betrag der Differenz aus dem Startwert V₃ und dem Testspannungswert V₄. Die Spannungskurve 420 verläuft bis zum Zeitpunkt t₈ auf dem Niveau des Startwerts V₃ und steigt dann geradlinig bis zum Zeitpunkt t₁₀ auf das Niveau des Testspannungswerts V₄. Nach dem Zeitpunkt t₁₀ sinkt die Spannungskurve 420 wieder auf das Niveau der ersten Betriebsspannung V₃. Das Zeitintervall Δt₄ ist definiert als die Zeitspanne zwischen dem Zeitpunkt t₈ und dem Zeitpunkt t₁₀. In dem in Fig. 4 gezeigten Ausführungsbeispiel der vorliegenden Erfindung wird das Zeitintervall Δt₃, Δt₄ gemessen und gemeinsam mit der vordefinierten Spannungsdifferenz ΔV die in der Energiereserve enthaltene Kapazität bestimmt. Durch einen Vergleich der so bestimmten Kapazität mit einer vordefinierten Kapazität für die Energiereserve kann eine Entscheidung über die Verfügbarkeit der Energiereserve getroffen werden.

In dem der Fig. 4 zugrunde liegenden Ausführungsbeispiel der vorliegenden Erfindung wird zum Zeitpunkt t₈ die untere Betriebsspannung V₃ verlassen, wobei die untere Betriebsspannung V₃ in diesem Ausführungsbeispiel der Betriebsspannung im Normalbetrieb entspricht. Von dem in Fig. 1c gezeigten Steuergerät wird nun veranlasst, dass die Ladespannung erhöht wird, bis die an der Energiereserve anliegende Spannung den oberen Betriebsspannungswert V₄ erreicht. Der Ladevorgang wird überwacht und die Zeitspanne für den Ladevorgang ermittelt. Aus der in Fig. 4 ermittelten Zeitspanne und der vorgegebenen Spannungsdifferenz kann die Überwachungseinrichtung die Kapazität der Energiereserve ermitteln. Zu dem Zeitpunkt, wenn die Betriebsspannung den oberen Betriebsspannungswert V₄ erreicht, wird von der Steuereinrichtung veranlasst, dass die Ladeschaltung deaktiviert und die Entladeschaltung aktiviert wird, bis die Betriebsspannung den unteren Betriebsspannungswert V₃ erreicht hat. Zu dem Zeitpunkt, an dem die Betriebsspannung den unteren Betriebsspannungswert V₃ erreicht, wird die Entladeschaltung deaktiviert und die Ladeschaltung wieder aktiviert.

Anders als bei den in Fig. 2 und Fig. 3 gezeigten Ausführungsbeispielen wird der Energiereserve-Elko beim Test gemäß des in Fig. 4 gezeigten Ausführungsbeispiels nicht zyklisch entladen, sondern über den Nominalwert, zum Beispiel 33V, geladen. Der DC/DC-Aufwärtswandler, der die Energiereserve-Spannung erzeugt, wird während des Tests auf einen höheren Sollwert gesetzt, z. B. 34V (also 1V über nominal 33V). Das Aufladen des Energiereserve-Elkos auf den neuen Sollwert erfolgt mit einem präzisen programmierten Strom. Es wird die Zeit gemessen, bis der neue Sollwert erreicht wird und daraus die Energiereserve-Kapazität (C=I^{∗}t/U) bestimmt und bewertet. Zum Ende des Tests wird der Sollwert des Aufwärtswandlers wieder auf den Nominalwert V₃, zum Beispiel 33V, gesetzt.

Dieses Ausführungsbeispiel hat den Vorteil, dass keine Nutzenergie aus dem Elko entnommen wird, allerdings soll sichergestellt sein, dass genügend Sicherheitsabstand zur Klammerspannung des internen ESD-Schutzes (typisch: 38V) garantiert ist.

Die zyklische Energiereserve-Überwachung kann folgendermaßen erfolgen: Die Ausführung und Wiederholung des Tests kann durch Software-Befehl erfolgen oder in einer Zustandsmaschine, auch als "State-Machine" bezeichnet, in Hardware abgebildet sein.

Die Energieentnahme bei den in den Figuren 2 und 3 exemplarisch gezeigten Ausführungsbeispielen wird durch kurze Testzeiten und geringe Energiereserve-Entladungen extrem klein gehalten, sodass die System-Verfügbarkeit nicht gefährdet und die Autarkiezeit nicht wesentlich reduziert wird. Durch eine langsame Wiederholrate im Sekunden-Bereich wird zudem erreicht, dass der Test keine Auswirkungen auf EMV-Verträglichkeit o.ä. hat.

Fig. 5 zeigt ein Ablaufdiagramm eines Verfahrens 500 zur Überwachung einer Energiereserve für eine Sicherungseinrichtung für ein Fahrzeug gemäß einem Ausführungsbeispiel der vorgestellten Erfindung. In einem Schritt 510 des Einlesens wird eine Spannung, auch als Klemmenspannung bezeichnet, an der Energiereserve eingelesen. Der die Spannung repräsentierende Wert kann, in Fig. 5 nicht dargestellt, in einem Schritt des Messens gemessen werden und dann in einem Schritt des Einlesens für das Verfahren 500 eingelesen werden, oder alternativ kann auch im Schritt 510 des Einlesens der Wert der Spannung über eine Schnittstelle eingelesen werden. In einem Schritt 520 des Auswertens wird die eingelesene Spannung ausgewertet, sodass Aussagen über die Spannungsänderung und gleichzeitig oder alternativ über die Zeit gemacht werden können. Aus der Auswertung im Schritt 520 des Auswertens kann eine Aussage über die Energiereserve getroffen werden, sodass in einem Schritt 530 ein Überwachungssignal erzeugt werden kann. Mittels des Überwachungssignals kann beispielsweise ein Fahrer des Fahrzeugs über eingeschränkte System-Funktionalität informiert werden.

## Patentansprüche

1. Verfahren (500) zur Überwachung einer Kapazität einer Energiereserve (105) für eine Sicherungseinrichtung (102) für ein Fahrzeug (100), welches folgende Schritte umfasst:
Ändern der an der Energiereserve (105) anliegenden Spannung (V) zwischen einem zum Betreiben der Sicherungseinrichtung (102) geeigneten Startwert (V₁, V₃) und einem zum Betreiben der Sicherungseinrichtung geeigneten Testspannungswert (V₂; V₄), wobei zum Ändern der Spannung (V) eine Ladeschaltung (115) der Energiereserve (105) deaktiviert wird und eine Entladeschaltung (125) der Energiereserve (105) aktiviert wird; und
Auswerten (520) der Spannungsänderung (ΔV) der an der Energiereserve (105) anliegenden Spannung (V) zwischen dem Startwert (V₁, V₃) und dem Testspannungswert (V₂; V₄), um die Energiereserve (105) zu überwachen;
**dadurch gekennzeichnet, dass**
die Schritte des Änderns und des Auswertens (520) mehrmals wiederholt während eines Fahrzyklus des Fahrzeugs (100) ausgeführt werden.

2. Verfahren (500) gemäß einem der vorangegangenen Ansprüche, bei dem im Schritt des Änderns die an der Energiereserve (105) anliegende Spannung (V) zwischen dem Testspannungswert (V₂; V₄) und dem Startwert (V₁; V₃) verändert wird.

3. Verfahren (500) gemäß einem der vorangegangenen Ansprüche, bei dem im Schritt (520) des Auswertens ausgewertet wird, ob die an der Energiereserve (105) anliegende Spannung (V) innerhalb einer vorbestimmten Zeitdauer den Testspannungswert (V₂; V₄) aufgrund der Spannungsänderung erreicht.

4. Verfahren (500) gemäß Anspruch 5, bei dem die an der Energiereserve (105) anliegende Spannung (V) auf den Startwert (V₁, V₃) geändert wird, sobald die an der Energiereserve (105) anliegende Spannung (V) innerhalb der vorbestimmten Zeitdauer den Testspannungswert (V₂; V₄) aufgrund der Spannungsänderung erreicht.

5. Verfahren (500) gemäß einem der vorangegangenen Ansprüche, bei dem im Schritt des Auswertens eine Zeitdauer der Spannungsänderung zwischen dem Startwert (V₁; V₃) und dem Testspannungswert (V₂; V₄) ausgewertet wird.

6. Verfahren (500) gemäß einem der vorangegangenen Ansprüche, bei dem der Startwert (V₁; V₃) kleiner als der Testspannungswert (V₂; V₄) ist.

7. Vorrichtung (108) zur Überwachung einer Energiereserve (105) für eine Sicherungseinrichtung (102) für ein Fahrzeug (100), die eine Änderungseinrichtung aufweist, die ausgebildet ist, um die an der Energiereserve (105) anliegenden Spannung (V) zwischen einem zum Betreiben der Sicherungseinrichtung (102) geeigneten Startwert (V₁, V₃) und einem zum Betreiben der Sicherungseinrichtung geeigneten Testspannungswert (V₂; V₄) zu ändern, wobei zum Ändern der Spannung (V) eine Ladeschaltung (115) der Energiereserve (105) deaktiviert wird und eine Entladeschaltung (125) der Energiereserve (105) aktiviert wird, und die eine Auswerteeinrichtung aufweist, die ausgebildet ist, um die Spannungsänderung (ΔV) der an der Energiereserve (105) anliegenden Spannung (V) zwischen dem Startwert (V₁, V₃) und dem Testspannungswert (V₂; V₄), um die Energiereserve (105) zu überwachen,
**dadurch gekennzeichnet, dass**
die Änderungseinrichtung und die Auswerteeinrichtung ausgebildet sind, die Schritte des Änderns und des Auswertens (520) mehrmals wiederholt während eines Fahrzyklus des Fahrzeugs (100) auszuführen.

8. Sicherungsvorrichtung für ein Fahrzeug mit folgenden Merkmalen:
einer Sicherungseinrichtung (102);
einer Energiereserve (105) für die Sicherungseinrichtung (102);
einer Ladeschaltung (115) zum Laden der Energiereserve (105);
einer Entladeschaltung (125) zum Entladen der Energiereserve (105); und
einer Vorrichtung (108) zur Überwachung der Energiereserve (105) gemäß Anspruch 7.

9. Computer-Programmprodukt mit Programmcode zur Durchführung des Verfahrens nach einem der Ansprüche 1 bis 6, wenn das Programm auf einem Computer ausgeführt wird.

## Claims

1. Method (500) for monitoring a capacity of an energy reserve (105) for a safety device (102) for a vehicle (100), which method comprises the following steps:
changing the voltage (V) present at the energy reserve (105) between a starting value (V₁; V₃) suitable for operating the safety device (102) and a test voltage value (V₂; V₄) suitable for operating the safety device, wherein, for changing the voltage (V), a charging circuit (115) of the energy reserve (105) is deactivated and a discharging circuit (125) of the energy reserve (105) is activated; and
evaluating (520) the voltage change (ΔV) of the voltage (V) present at the energy reserve (105) between the starting value (V₁; V₃) and the test voltage value (V₂; V₄) in order to monitor the energy reserve (105);
**characterized in that**
the steps of changing and evaluating (520) are carried out repeatedly a number of times during a driving cycle of the vehicle (100).

2. Method (500) according to one of the preceding claims, wherein the step of changing involves altering the voltage (V) present at the energy reserve (105) between the test voltage value (V₂; V₄) and the starting value (V₁; V₃).

3. Method (500) according to either of the preceding claims, wherein the step (520) of evaluating involves evaluating whether the voltage (V) present at the energy reserve (105) reaches the test voltage value (V₂; V₄) on account of the voltage change within a predetermined time duration.

4. Method (500) according to Claim 5, wherein the voltage (V) present at the energy reserve (105) is changed to the starting value (V₁; V₃) as soon as the voltage (V) present at the energy reserve (105) reaches the test voltage value (V₂; V₄) on account of the voltage change within the predetermined time duration.

5. Method (500) according to any of the preceding claims, wherein the step of evaluating involves evaluating a time duration of voltage change between the starting value (V₁; V₃) and the test voltage value (V₂; V₄).

6. Method (500) according to any of the preceding claims, wherein the starting value (V₁; V₃) is less than the test voltage value (V₂; V₄).

7. Apparatus (108) for monitoring an energy reserve (105) for a safety device (102) for a vehicle (100), which apparatus comprises a changing device configured to change the voltage (V) present at the energy reserve (105) between a starting value (V₁; V₃) suitable for operating the safety device (102) and a test voltage value (V₂; V₄) suitable for operating the safety device, wherein, for changing the voltage (V), a charging circuit (115) of the energy reserve (105) is deactivated and a discharging circuit (125) of the energy reserve (105) is activated, and which apparatus comprises an evaluation device configured to the voltage change (ΔV) of the voltage (V) present at the energy reserve (105) between the starting value (V₁; V₃) and the test voltage value (V₂; V₄) in order to monitor the energy reserve (105),
**characterized in that**
the changing device and the evaluation device are configured to carry out the steps of changing and evaluating (520) repeatedly a number of times during a driving cycle of the vehicle (100).

8. Safety apparatus for a vehicle having the following features:
a safety device (102);
an energy reserve (105) for the safety device (102);
a charging circuit (115) for charging the energy reserve (105);
a discharging circuit (125) for discharging the energy reserve (105); and
an apparatus (108) for monitoring the energy reserve (105) according to Claim 7.

9. Computer program product having program code for carrying out the method according to any of Claims 1 to 6 when the program is executed on a computer.

## Revendications

1. Procédé (500) de surveillance d'une capacité d'une réserve d'énergie (105) pour un dispositif de sécurité (102) pour un véhicule (100), qui comprend les étapes suivantes :
modification de la tension (V) appliquée à la réserve d'énergie (105) entre une valeur de départ (V₁, V₃) appropriée pour le fonctionnement du dispositif de sécurité (102) et une valeur de tension de test (V₂ ; V₄) appropriée pour le fonctionnement du dispositif de sécurité, dans lequel, pour modifier la tension (V), un circuit de charge (115) de la réserve d'énergie (105) est désactivé et un circuit de décharge (125) de la réserve d'énergie (105) est activé ; et
évaluation (520) de la modification de tension (ΔV) de la tension (V) appliquée à la réserve d'énergie (105) entre la valeur de départ (V₁, V₃) et la valeur de tension de test (V₂ ; V₄) afin de de surveiller la réserve d'énergie (105) ;
**caractérisé en ce que**
les étapes de modification et d'évaluation (520) sont répétées à plusieurs reprises pendant un cycle de roulement du véhicule (100).

2. Procédé (500) selon une des revendications précédentes, dans lequel, dans l'étape de modification, la tension (V) appliquée à la réserve d'énergie (105) est modifiée entre la valeur de tension de test (V₂ ; V₄) et la valeur de départ (V₁, V₃).

3. Procédé (500) selon une des revendications précédentes, dans lequel, dans l'étape (520) d'évaluation, on évalue si la tension (V) appliquée à la réserve d'énergie (105) atteint la valeur de tension de test (V₂ ; V₄) sur une durée prédéfinie en raison de la modification de tension.

4. Procédé (500) selon la revendication 5, dans lequel la tension (V) appliquée à la réserve d'énergie (105) est passée à la valeur de départ (V₁, V₃) dès que la tension (V) appliquée à la réserve d'énergie (105) atteint la valeur de tension de test (V₂ ; V₄) sur la durée prédéfinie en raison de la modification de tension.

5. Procédé (500) selon une des revendications précédentes, dans lequel, dans l'étape d'évaluation, une durée de la modification de tension entre la valeur de départ (V₁, V₃) et la valeur de tension de test (V₂ ; V₄) est évaluée.

6. Procédé (500) selon une des revendications précédentes, dans lequel la valeur de départ (V₁, V₃) est inférieure à la valeur de tension de test (V₂ ; V₄)

7. Dispositif (108) de surveillance d'une réserve d'énergie (105) pour un dispositif de sécurité (102) pour un véhicule (100), qui présente un dispositif de modification qui est conçu pour modifier la tension (V) appliquée à la réserve d'énergie (105) entre une valeur de départ (V₁, V₃) appropriée pour le fonctionnement du dispositif de sécurité (102) et une valeur de tension de test (V₂ ; V₄) appropriée pour le fonctionnement du dispositif de sécurité, dans lequel, pour modifier la tension (V), un circuit de charge (115) de la réserve d'énergie (105) est désactivé et un circuit de décharge (125) de la réserve d'énergie (105) est activé ; et qui présente un dispositif d'évaluation qui est conçu pour la modification de tension (ΔV) de la tension (V) appliquée à la réserve d'énergie (105) entre la valeur de départ (V₁, V₃) et la valeur de tension de test (V₂ ; V₄) afin de surveiller la réserve d'énergie (105) ; **caractérisé en ce que**
le dispositif de modification et le dispositif d'évaluation sont conçus pour exécuter les étapes de modification et d'évaluation (520) à plusieurs reprises pendant un cycle de roulement du véhicule (100).

8. Dispositif de sécurité pour véhicule, présentant les caractéristiques suivantes :
un dispositif de sécurité (102) ;
une réserve d'énergie (105) pour le dispositif de sécurité (102) ;
un circuit de charge (115) pour charger la réserve d'énergie (105) ;
un circuit de décharge (125) pour décharger la réserve d'énergie (105) ; et
un dispositif (108) de surveillance de la réserve d'énergie (105) selon la revendication 7.

9. Produit de programmation informatique comportant un code de programme pour la réalisation du procédé selon une des revendications 1 à 6 lorsque le programme est exécuté sur un ordinateur.
